(19) Europäisches Patentamt
European Patent Office
Office européen des brevets

(11) **EP 2 091 148 A1**

(12) **DEMANDE DE BREVET EUROPEEN**

(43) Date de publication:
**19.08.2009 Bulletin 2009/34**

(51) Int Cl.:
***H03H 9/60*** *(2006.01)*

(21) Numéro de dépôt: **09368005.6**

(22) Date de dépôt: **13.02.2009**

(84) Etats contractants désignés:
**AT BE BG CH CY CZ DE DK EE ES FI FR GB GR HR HU IE IS IT LI LT LU LV MC MK MT NL NO PL PT RO SE SI SK TR**
Etats d'extension désignés:
**AL BA RS**

(30) Priorité: **15.02.2008 FR 0800827**

(71) Demandeurs:
• **STMicroelectronics SA**
**92120 Montrouge (FR)**
• **Centre National de la Recherche Scientifique (C.N.R.S.)**
**75796 Paris Cedex 15 (FR)**

(72) Inventeurs:
• **Belot, Didier**
**38140 Rives (FR)**
• **Shirakawa, Alexandre Augusto**
**33405 Talence (FR)**
• **Deval, Yann**
**33800 Bordeaux (FR)**
• **Kerherve, Eric**
**33400 Talence (FR)**
• **El Hassan, Moustapha**
**33400 Talence (FR)**

(74) Mandataire: **Schuffenecker, Thierry**
**Cabinet Thierry Schuffenecker**
**120, Chemin de la Maure**
**06800 Cagnes sur Mer (FR)**

(54) **Filtre à résonateurs acoustiques de type BAW reconfigurable par voie numérique et procédé**

(57) Circuit de filtrage à résonateurs acoustique de type BAW comportant au moins un premier et un second quadripôles connectés en cascade, lesdits quadripôles comportant chacun une branche série (315, 325) doté d'un premier résonateur acoustique de type BAW (311, 321, 331) et d'une branche parallèle (316 et 326) dotée chacune d'un résonateur acoustique de type BAW (312, 322, 332), ledit premier résonateur acoustique (311, 321, 331) ayant une fréquence de résonance série sensiblement également à la fréquence de résonance parallèle dudit second résonateur acoustique (312, 322, 332) ; **caractérisé en ce que** la branche parallèle (316, 336) dudit premier quadripôle comporte une première capacité (313) connectée en série avec ledit second résonateur et, en parallèle avec ladite capacité, un premier transistor de commutation (314) destiné à court-circuiter ladite capacité.

Fig. 3

EP 2 091 148 A1

## EP 2 091 148 A1

**Description**

**Domaine technique de l'invention**

La présente invention concerne les circuits électroniques et notamment un circuit de filtrage comportant des résonateurs acoustiques BAW reconfigurables numériquement.

**Etat de la technique**

Les résonateurs acoustiques sont aujourd'hui très répandus dans les applications grand-public mais également dans les applications professionnelles en raison de leur grande efficacité, notamment pour la réalisation de filtres passe-bandes très performants, et ce notamment en téléphonie mobile pour la sélection des canaux de transmission.
Les recherches ont porté sur deux types de résonateurs acoustiques qui présentent des performances remarquables, à savoir les résonateurs de type SAW (*Surface Acoustic Resonator*) et, plus récemment, ceux de type BAW (*Bulk Acoustic Resonator*). Dans les premiers, le résonateur acoustique est situé sur la surface d'un produit semiconducteur tandis que, dans les seconds, il est disposé à l'intérieur d'un volume délimité entre une électrode inférieure et une électrode supérieure en sorte que l'onde acoustique se développe dans ce même volume. Les résonateurs de type BAW font l'objet d'intenses recherches par les fabricants de produits semi-conducteurs car ces composants permettent d'envisager une intégration très poussée des circuits de filtrage et, par conséquent, laissent entrevoir une baisse significative du coût de fabrication de ces mêmes circuits.
Les résonateurs de type BAW permettent d'envisager des fréquences plus élevées que celles mises en oeuvres par les SAW, tout en offrant un encombrement particulièrement réduit.
Au-delà des performances offertes par les résonateurs de type BAW pour la réalisation d'un filtre numérique, on constate un besoin de permettre une configuration aisée des caractéristiques de filtrages d'un filtre composé de résonateurs de type BAW.
Cette configuration est effectuée, jusqu'à présent au moyen de varactor que l'on vient connecter en série ou en parallèle sur les résonateurs et que l'on vient commandant en appliquant une tension analogique.
Un tel dispositif, s'il présente un certain intérêt, nécessite cependant une commande complexe, requérant un circuit analogique sophistiqué.
Il est souhaitable de simplifier la conception de la commande de l'ajustage des résonateurs acoustiques utilisés dans les circuits de filtrages, afin de permettre notamment une commande plus sophistiquée tout en étant moins coûteuse à mettre en oeuvre.
Tel est l'objet de la présente demande de brevet.

**Exposé de l'invention**

La présente invention a pour but de proposer une structure de filtre - adapté à la téléphonie mobile - composé de résonateurs acoustiques de type BAW qui soit aisément configurable.
Un autre but de la présente invention consiste à proposer un filtre comportant des résonateurs acoustiques peu coûteux à réaliser et qui permettent d'emblée une commande complètement numérique de l'ajustage en fréquence.
Un troisième but de la présente invention consiste à réaliser un circuit de filtrage comportant des résonateurs BAW parfaitement intégrable sur un substrat de semi-conducteur et aisément configurable par voie numérique.
L'invention réalise ces buts au moyen d'un circuit de filtrage à résonateurs acoustique de type BAW comportant au moins un premier et un second quadripôles connectés en cascade, lesdits quadripôles comportant chacun une branche série dotée d'un premier résonateur acoustique de type BAW et d'une branche parallèle dotée également d'un résonateur acoustique de type BAW . Le premier résonateur BAW présente une fréquence de résonance série sensiblement également à la fréquence de résonance parallèle dudit second résonateur acoustique .
Le circuit est caractérisé en ce que la branche parallèle du premier quadripôle comporte une première capacité connectée en série avec ledit second résonateur et, en parallèle avec ladite capacité, un premier transistor de commutation commandé par un premier potentiel de commande et permettant de court-circuiter ladite capacité.
Dans un mode de réalisation, le second quadripôle comporte une seconde capacité connectée en série avec ledit second résonateur et, en parallèle avec celle-ci, un second transistor de commutation commandé par un second potentiel de commande et destiné à court-circuiter ladite capacité.
Ainsi, les potentiels de commande des premier, second (et plus le cas échéant) transistors de commutation permettent de constituer un bus de commande complètement numérique permettant la commande des caractéristiques de filtrage du circuit doté des résonateurs acoustiques.
Ainsi, on peut envisager d'emblée une commande parfaitement numérique du circuit de filtrage et ce au moyen de moyens de traitement numérique appropriés. On évite ainsi le recours à des composants analogiques, tels que des varactors coûteux et délicats à mettre en oeuvre.

Dans un mode de réalisation particulier, les résonateurs sont tous de type *Surface Mounted Resonator* (SMR) disposés sur un miroir de Bragg.

Dans un mode de réalisation particulier, le circuit de filtrage sert à la réalisation d'un circuit de réception en téléphonie mobile de 4ème génération.

L'invention réalise également un procédé de réduction de l'interférence subie par un circuit de réception pour un téléphone mobile comportant un circuit de filtrage basé sur une cascade de cellules comportant chacune une branche parallèle dotée d'un premier BAW, et une branche série dotée d'un second BAW, ledit second BAW étant monté en série avec une capacité disposant d'un transistor de commutation branché à ses bornes.

Le procédé comportant les étapes suivantes :

- détection de la présence d'un signal perturbateur proche de la bande d'utilisation du mobile susceptible de perturber la communication en cours,
- en réponse à une éventuelle détection, commande numérique d'un ou plusieurs transistors de manière à venir introduire l'effet des capacités en série avec les résonateurs des branches parallèles pour modifier les poles du filtre et accroître la sélectivité de ce dernier.

## Description des dessins

D'autres caractéristiques, but et avantages de l'invention apparaîtront à la lecture de la description et des dessins ci-après, donnés uniquement à titre d'exemples non limitatifs. Sur les dessins annexés :

Les 1A et 1B illustrent respectivement la structure d'un résonateur BAW de type FBAR ou SMR.

Les figures 2A et 2B illustrent respectivement le modèle BVD ainsi que la courbe d'impédance caractéristique du résonateur dans le voisinage des fréquences de résonance.

La figure 3 illustre la structure générale d'un mode de réalisation d'un circuit de filtrage configurable numérique conforme à la présente invention.

les figures 4A et 4B le modèle électrique équivalent de la branche parallèle des cellules 310-330, ainsi que la courbe d'impédance caractéristiques en fonction de la valeur de la capacité C connectée en série sur le résonateur.

La figure 5 illustre la courbe d'impédance des résonateurs BAW dans les branches série et parallèle, et la courbe d'impédance de la cellule qui en résulte.

La figure 6 montre l'évolution de la réponse en fréquence du filtre lorsque les trois capacités de la figure 3 sont toutes mises en oeuvre.

La figure 7 illustre une version simplifié du circuit de la figure 3 réalisant un filtre du cinquième ordre adapté au standard W-CDMA.

Les figures 8A, 8B , 8C et 8D illustrent sont des courbes de réponse en fréquence du filtre en fonction de la commande numérique des transistors 314, 324 et 334.

La figure 9 illustre un mode de réalisation d'un procédé de commande d'un filtre à résonateur numérique conforme à la présente invention.

## Description d'un mode de réalisation préféré

On décrira à présent un mode de réalisation d'un circuit de filtrage reconfigurable conforme à la présente invention qui est particulièrement adapté à la réalisation d'un circuit de réception d'un signal RF utilisable notamment en téléphonie mobile, et intégrable sur circuit de type *Very Large Scale Integration* (VLSI). En téléphonie mobile, et notamment dans les applications les plus récentes telles que le *Wide Code Division Multiplexing Access* (WCDMA), on rencontre la nécessité d'opérer un filtrage particulièrement performant afin de pouvoir séparer des canaux particulièrement proches. Il est à noter qu'il ne s'agit là que d'un exemple non limitatif d'utilisation du filtre que l'on va décrire ci-après.

Le circuit de filtrage comporte un ensemble de résonateurs acoustiques de type Bulk Acoustic Wave (B.A.W.) que l'on réalise au moyen de techniques connues de dépôt de couches minces (*thin Film*) au moyen de techniques de pulvérisation (*sputtering*)*,* d'évaporation sous vide ou de dépôt CVD (*Chemical Vapor Deposition*) bien connues.

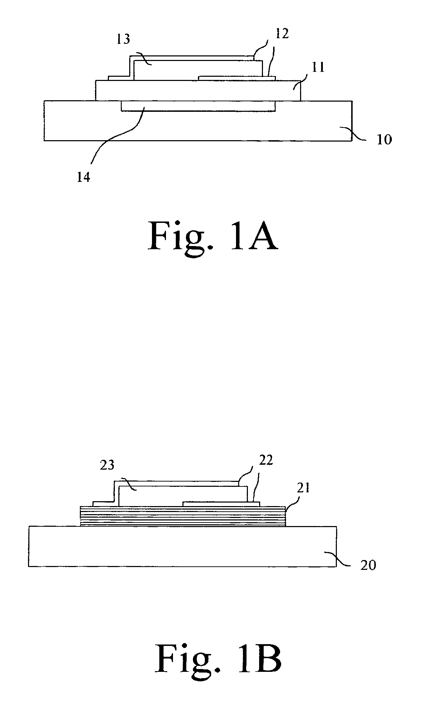

La figure 1 illustre plus particulièrement la structure d'un résonateur BAW de type *Film Bulk Acoustic Resonator* (FBAR) qui se compose d'une couche de matériau piezzo électrique 13 présentant des caractéristiques acoustiques, d'électrodes 12 enserrant cette couche et d'une isolation acoustique de l'ensemble par rapport à un substrat de silicium substrat 100 réalisé en silicium (Si), en arséniure de Gallium ( GaAs), en verre ou en céramique. Le matériau piézo électrique peut être ZnO, ALN, ZnS ou toute céramique ferroélectrique connue d'un homme du métier. Les électrodes peuvent être réalisées métal quelconque adapté à l'application recherchée, tel que, par exemple, du tungstène (W), de l'aluminium (AL), du cuivre (Cu), du molybdène (MO), du nickel (Ni), du titane (Ti), de l'argent (Ag), de l'or (Au) ou du tantale (Ta).

Dans la structure de la figure 1, l'isolation acoustique est réalisée au moyen d'une membrane 11 disposée au dessus d'une cavité 14 assurant l'isolation par rapport au substrat 10.

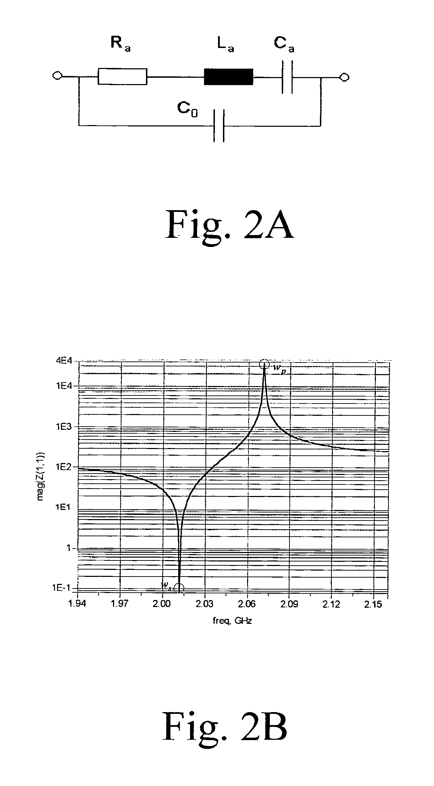

La figure 2 illustre plus particulièrement une structure duale d'un résonateur connu dans la littérature sous la désignation anglo-saxonne *Surface Mounted Resonator* (SMR). On voit en effet le résonateur composé de deux électrodes 22 enserrant une couche 23 disposé au dessus d'un élément réfléchissant tel un récepteur ou miroir de Bragg 21 par exemple. Ce miroir réfléchissant se compose d'un empilement de couches présentant des propriétés acoustiques et des constantes diélectriques différentes, disposé sur un substrat 20. De cette manière, on assure une déperdition minimale des ondes acoustiques au sein du substrat 20.

Le circuit de filtrage que l'on décrira ci-après sera réalisé au moyen de résonateur de type SMR qui apparaissent particulièrement adapté à cet usage. Clairement, un homme du métier pourra néanmoins réaliser l'invention au moyen de résonateurs de type FBAR.

Le circuit qui sera décrit plus loin comportera exclusivement des résonateurs de type SMR tels que représentés dans la figure 2, mais il est clair qu'un homme du métier pourra réaliser l'invention en substituant à ces résonateurs SMR des résonateurs de type FBAR et l'invention n'est absolument pas limité par la technique particulière d'isolation acoustique mise en oeuvre pour la réalisation du résonateur BAW.

Dune manière générale, le procédé de fabrication d'un résonateur de type BAW, qu'il s'agisse d'un résonateur de type FBAR ou SMR, est bien connu et ne sera pas décrit plus avant. Les fréquences de résonances des résonances BAW varient typiquement de 0.5 Ghz à 5 Ghz et ces valeurs de la nature du matériau utilisé et des épaisseurs de couche qui sont mises en oeuvre.

Le résonateur BAW présente deux fréquences de résonance qui sont caractéristiques de la nature du matériau piézo-électrique utilisé ( ZnO, ALN, ZnS ou toute céramique ferroélectrique connue d'un homme du métier)

La figure 2 illustre le schéma électrique équivalent d'un résonateur BAW, classiquement désigné par l'appelation *Butterworth-Van-Dyke (BVD),* avec Ra, La et Ca rendant compte de la fréquence de résonance acoustiques et des pertes acoustiques. La valeur de la capacité $C_0$ représentée sur la figure 2 correspondant à la capacité physique entre les deux électrodes du résonateur.

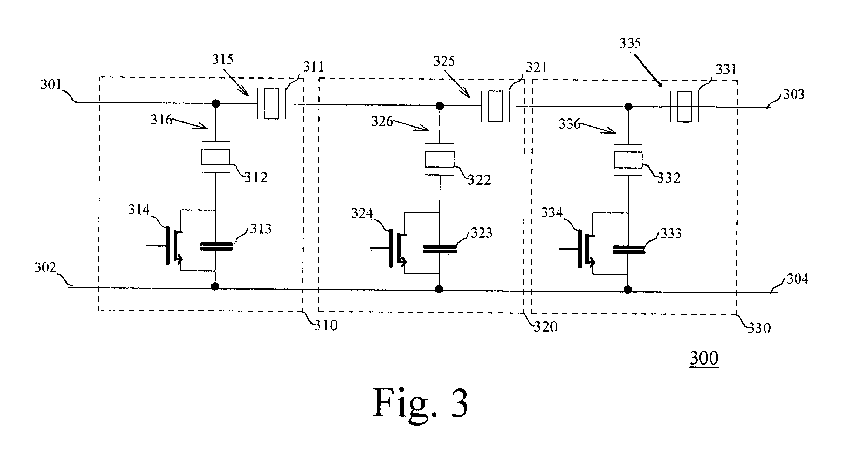

La figure 3 illustre la courbe caractéristique d'un résonateur, mettant en évidence deux pulsations de résonance, respectivement série ($\omega s$ correspondant à une impédance minimale) et parallèle ($\omega p$ correspondant à une impédance maximale). Hors le voisinage des deux pulsations de résonance, le résonateur se comporte de manière capacitive

Les valeurs des pulsations $\omega s$ et $\omega p$ dépendent de l'épaisseur du matériau piézo-électrique et l'écart entre ces deux valeurs résulte du coefficient de couplage électromécanique.

Le schéma équivalent BVD présente une impédance que l'on peut calculer selon une formule simplifiée :

$$Z_{SMR} = \frac{1}{jwC_0} \frac{(w^2 - w_s^2)}{(w^2 - w_p^2)}$$

On décrit à présent en relation avec la figure 3 le schéma de principe d'un mode de réalisation d'un filtre 300 conforme à la présente invention.

Le filtre se compose d'un ensemble de cellules, respectivement 310-330, qui se présentent chacune sous la forme d'un quadripôle.

La cellule 310 comporte deux entrées, respectivement 301 et 302, et deux sorties (non numérotées) qui sont connectées aux deux entrées du quadripôle formant la cellule suivante 320 etc... Sur la figure 3, on voit que le quadripôle de la cellule 330 dispose de deux sorties 303 et 304 qui sont les électrodes de sortie du filtre.

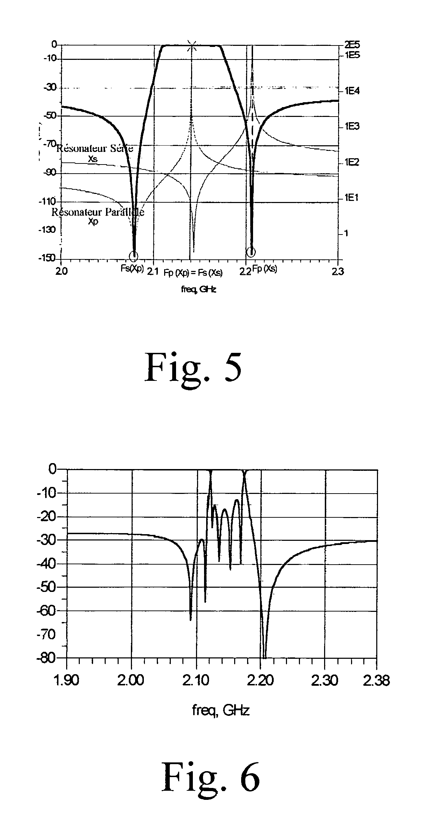

Chacun des quadripôles que constituent les cellules 310-330 se compose d'une branche série (resp. 315, 325, 335) comportant un premier résonateur BAW (resp. 311, 321, 331), et une branche parallèle (resp. 316, 326, 336) comportant un second résonateur BAW (resp. 312, 322, 332). Les résonateurs BAW (resp. 312, 322, 332) de la branche parallèle sont dimensionnés pour présenter une fréquence de résonance parallèle (anti-résonance) sensiblement égale à la fréquence de résonance série du résonateur BAW (resp. 311, 321, 3312) dans la branche série comme cela est illustré dans la figure 5.

Dans le mode de réalisation représenté dans la figure 3, chacune des branches parallèles 316 et 326 comportent une capacité (resp. 313, 323, 333) connectée en série avec le résonateur BAW parallèle (resp. 312, 322, 332).

En outre, un transistor MOS (resp. 314, 324 et 334) dispose de deux électrodes de source et de drain qui sont connectées en parallèle sur la capacité (resp. 313, 323, 333) et d'une électrode de grille recevant un potentiel de commande permettant de commander le court-circuit ou non de la capacité.

La figure 3 illustre ainsi un ensemble de trois cellules en cascade, parfaitement identiques, comportant chacune une capacité (resp. 313, 323 et 333) permettant de faire varier sensiblement les caractéristiques de la cellule individuelle.

Il convient toutefois d'observer qu'il n'est pas indispensable que toutes les cellules soit agencées avec une capacité et qu'un homme du métier pourra décider de ne pas introduire, dans une cellule prédéterminée, une capacité dans la branche parallèle de cette dernière.

La figure 3 met ainsi en évidence un circuit de filtrage, doté de résonateurs BAW situés respectivement dans les branches série et parallèle de chacune des cellules, ainsi qu'un ensemble d'électrodes de commande composant un véritable bus numérique permettant une commande de nature numérique des caractéristiques acoustiques du résonateur.

Le circuit de la figure 3 offre ainsi une solution particulièrement élégante et bon marché pour réaliser une interface de commande numérique pour un filtre doté de résonateurs BAW, permettant d'effectuer à bon marché un traitement numérique sophistiqué.

Il suffit en effet de présenter sur l'ensemble des électrodes de grille des potentiels « 0 » ou « 1 » permettant de venir fixer les points de fonctionnement des différents résonateurs acoustiques pour, en fin de compte, obtenir une réponse globale du filtre acoustique, d'emblée numérique et qui peut être fournie directement par un DSP sans même recourir à un quelconque convertisseur numérique analogique.

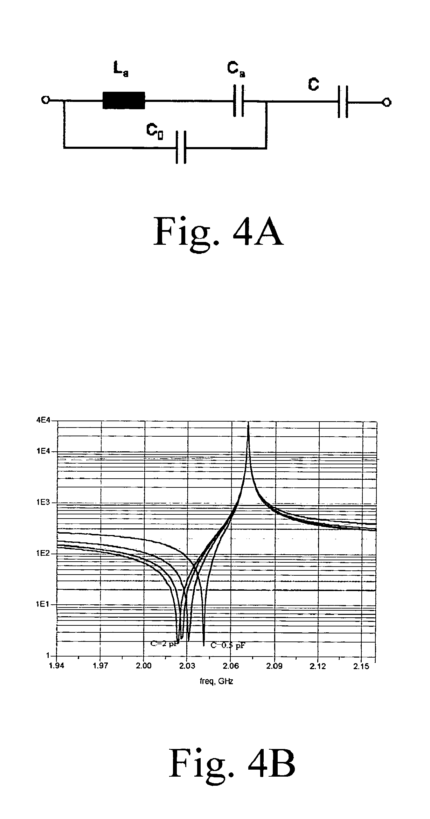

Dans un souci de clarté, on a représenté dans les figures 4A et 4B le modèle électrique équivalent de la branche parallèle des cellules 310-330, ainsi que la courbe d'impédance caractéristiques en fonction de la valeur de la capacité C connectée en série sur le résonateur.

D'une manière générale, les capacités sont des composants passifs qui présentent un facteur de qualité dont la valeur se situe dans une gamme de 30 à 50. En outre, dans le mode de réalisation décrit, les capacités sont intégrées dans la branche « parallèle », ce qui porte peu préjudice au facteur de qualité global de la cellule de filtrage. Ceci est un avantage sensible du circuit de filtrage décrit, et ce malgré son apparente simplicité.

Si l'on examine, d'un point de vue théorique, l'effet de l'introduction de la capacité 313 dans la branche parallèle comportant déjà le résonateur 312, on démontre que l'impédance se calcule au moyen de la formule ci-après :

$$Z_{in} = \frac{s^2\left(CC_aL_a + C_0C_aL_a\right) + C_0 + C_a + C}{sC\left(s^2C_0C_aL_a + C_0 + C_a\right)} \qquad (I)$$

On observe ainsi l'introduction d'un pôle et d'un zéro par rapport à la valeur de l'impédance du seul résonateur parallèle. Les calculs d'extraction du pôle et du zéro conduisent aux formules (II) et (III) suivantes :

$$s^2\left(CC_aL_a + C_0C_aL_a\right) + C_0 + C_a + C = 0$$

$$s^2 = -\frac{C_0 + C_a + C}{\left(CC_aL_a + C_0C_aL_a\right)} \qquad (II)$$

$$sC\left(s^2 C_0 C_a L_a + C_0 + C_a\right) = 0$$

$$s = 0 \ and \ s^2 = -\frac{C_0 + C_a}{C_0 C_a L_a} \qquad\qquad (III)$$

L'équation (III) met en évidence l'insertion d'un pole à la fréquence nulle, mais l'on observe que les autres valeurs ne sont pas modifiées. L'équation (II) montre également que l'association en série d'une capacité et d'un résonateur entraîne la modification des zéros dans la réponse en fréquence. Plus particulièrement, en introduisant une valeur de capacité, on note que la fréquence de résonance série est déplacée vers la gauche, tandis que la valeur statique de la capacité du résonateur tend à décroître.

La figure 4B illustre plus particulièrement cet effet du à l'introduction d'une capacité en série avec un résonateur situé dans la branche parallèle d'une cellule. Comme on le voit sur la figure, les résonateurs des résonateurs dits SERIE ( ou Xs qui sont situés dans une branche série d'une cellule) présentent des fréquences de résonance légèrement plus élevées que celles des résonateurs dits PARALLELE (ou Xp). Les résonances séries ($\omega$s) des résonateurs PARALLELE déterminent la position des zéros de telle manière qu'un changement dans leur impédance conduit à une variation de ces mêmes zéros.

En se référant à nouveau au modèle BVD, on peut montrer que les valeurs des fréquences de résonance série et parallèle sont données par les formules suivantes :

$$f_s = \frac{1}{2\pi}\sqrt{\frac{1}{L_a C_a}}$$

$$f_p = \frac{1}{2\pi}\sqrt{\frac{C_a + C_0}{L_a C_a C_0}}$$

Suite à l'introduction d'une valeur de capacité C, et en se référant à la formule (II) précédente, on voit que la fréquence de résonance série devient alors :

$$f_s = \frac{1}{2\pi}\sqrt{\frac{C_0 + C_a + C}{\left(C C_a L_a + C_0 C_a L_a\right)}}$$

Comme on le voit, on parvient ainsi à opérer un réglage fin des caractéristique du filtre en venant modifier une ou plusieurs cellules composant le filtre de la figure 3.

La figure 6 illustre l'évolution de la réponse en fréquence du filtre lorsque les trois capacités 313, 323 et 333 sont toutes mises en oeuvre.

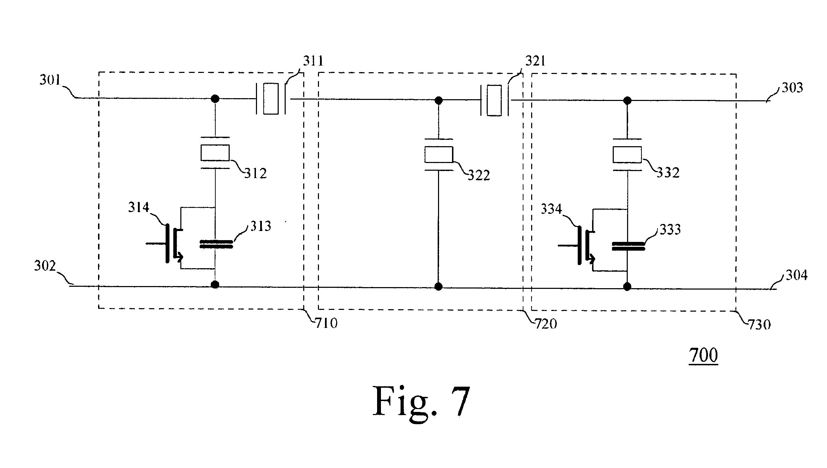

La figure 7 illustre une version simplifiée du circuit de filtrage 700 de la figure 3 ne comportant que trois cellules 710, 720 et 730. La cellule 710 est identique à la cellule 310 de la figure 3. La cellule 720 ne comporte aucune capacité dans sa branche parallèle, tandis que la cellule 730 ne comporte pas de résonateur BAW dans sa branche série, contrairement à la cellule 330 de la figure 3.

Dans un souci de clarté, les éléments inchangés par rapport à ceux de la figure 3 conservent leur référence et l'on voit que le filtre 700 se distingue du filtre de la figure 3 par la suppression de la capacité 323, du transistor 324 et du résonateur 331.

Le circuit de filtrage de la figure 7 se présente ainsi comme un circuit du cinquième ordre, bon marché à réaliser, et qui peut être finement accordé, de manière complètement numérique, au moyen des tensions de commandes sur les grilles des transistors 314 et 334. On a observé que ce circuit, peu coûteux à réaliser, s'avère adapté à la réalisation d'un circuit de réception conforme à la norme WCDMA (2110-2170 MHz).

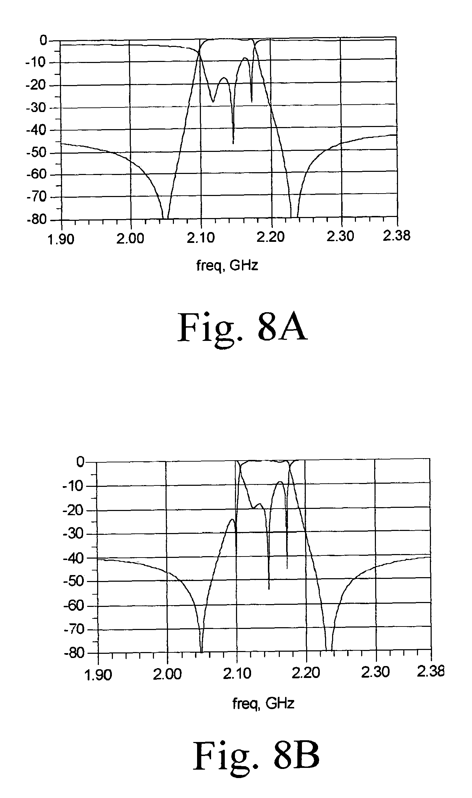

La figure 8A illustre en effet la réponse en fréquence du filtre lorsque les transistors 314 et 334 sont tous deux mis en état de conduction forcée, court-circuiter ainsi respectivement les capacités 313 et 333. On voit que dans cette configuration, le filtre (2103-2177 MHz) n'est pas conforme au standard W-CDMA.

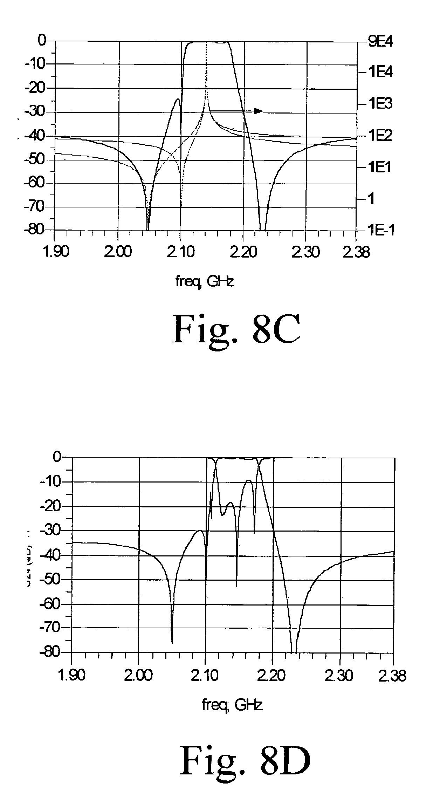

Pour rendre le filtre conforme, on procède alors au blocage du transistor 314, ce qui met en oeuvre la capacité 313, et réduisant ainsi de 20% la largeur de bande du filtre (2110 -2170 MHz), comme cela est illustré dans la figure 8B. On observe ainsi l'effet résultant de l'insertion de la capacité 313 sur le déplacement des zéros, illustré dans la figure 8C.

On constate enfin que lorsque l'on bloque les deux transistors 314 et 334, on vient réduire encore d'avantage la largeur de la bande par l'effet conjugué des deux capacités.

Cette réduction est illustrée dans la courbe de réponse en fréquence de la figure 8D.

L'invention trouve avantageusement application en téléphonie mobile, lorsqu'un circuit réception se trouve située dans une zone dans laquelle un autre téléphone mobile émet et est susceptible de venir entrer en interférence et perturber le fonctionnement du circuit récepteur.

Dans une telle situation, il est particulièrement avantageux de venir commander les transistors dans les branches parallèles pour venir déplacer les pôles et accroître la sélectivité du circuit, par exemple par une augmentation de 30dB de cette dernière.

## Revendications

1. Circuit de filtrage à résonateurs acoustique de type BAW comportant au moins un premier et un second quadripôles connectés en cascade, lesdits quadripôles comportant chacun une branche série (315, 325) dotée d'un premier résonateur acoustique de type BAW (311, 321, 331) et d'une branche parallèle (316 et 326) dotée d'un second résonateur acoustique de type BAW (312, 322, 332), ledit premier résonateur acoustique (311, 321, 331) ayant une fréquence de résonance série sensiblement également à la fréquence de résonance parallèle dudit second résonateur acoustique (312, 322, 332) ;
**caractérisé en ce que** la branche parallèle (316, 336) dudit premier quadripôle comporte une première capacité (313) connectée en série avec ledit second résonateur et, en parallèle avec ladite capacité, un premier transistor de commutation (314) destiné à court-circuiter ladite capacité.

2. Circuit de filtrage selon la revendication 1 **caractérisé en ce que** ledit second quadripôle comporte une seconde capacité (313) connectée en série avec ledit second résonateur et, en parallèle avec ladite capacité, un second transistor de commutation (324) destiné à court-circuiter ladite capacité.

3. Circuit de filtrage selon la revendication 2 **caractérisé en ce que** les potentiels de commande desdits premiers et second transistors font partie d'un bus de commande numérique destiné à la commande de l'accord dudit circuit de filtrage.

4. Circuit de filtrage selon l'une quelconque des revendications 1 à 3 **caractérisé en ce que** les résonateurs sont des résonateurs de type Surface Mounted Resonator disposés sur un miroir de Bragg.

5. Circuit de filtrage selon l'une quelconque des revendications 1 à 4 **caractérisé en ce qu'**il est destiné à la réalisation d'un circuit de réception pour téléphonie mobile.

6. Circuit de filtrage à résonateur acoustiques selon la revendication 1 adapté à la norme W- CDMA comportant :

- un premier quadripôle (710) comportant deux électrodes d'entrée (301, 302), deux électrodes de sortie, une branche série (315) et une branche parallèle (316), ladite branche série (315) comportant un premier résonateur de type BAW (311) présentant une fréquence de résonance série et une fréquence de résonance parallèle et ladite branche parallèle (316) comportant un second résonateur de type BAW comportant une fréquence de résonance série et une fréquence de résonance parallèle, ladite fréquence de résonance parallèle dudit second résonateur étant fixée pour coïncider avec la fréquence de résonance série dudit premier résonateur, ladite branche parallèle comportant une première capacité (313) en série avec ledit second résonateur (312) et, en parallèle sur cette capacité, un transistor de commutation (314) permettant de court-circuiter cette capacité et pouvant être commandé par un premier potentiel de commande ;
- un second quadripôle (720) connecté en cascade derrière ledit premier quadripôle, et comportant deux électrodes d'entrée, deux électrodes de sortie, une branche série (325) et une branche parallèle (326), ladite branche série comportant un troisième résonateur de type BAW (321) présentant une fréquence de résonance série et une fréquence de résonance parallèle et ladite branche parallèle du second quadripôle comportant un quatrième résonateur de type BAW présentant une fréquence de résonance série et une fréquence de résonance parallèle, ladite fréquence de résonance parallèle dudit quatrième résonateur étant fixée pour coïncider avec la fréquence de résonance série dudit troisième résonateur ;

- un troisième quadripôle (730) connecté en cascade derrière ledit second quadripôle, ledit troisième quadripôle comportant deux électrodes d'entrée, deux électrodes de sortie, une branche série et une branche parallèle, ladite branche série ne comportant aucun résonateur, et ladite branche parallèle dudit troisième quadripôle comportant un résonateur de type BAW comportant une fréquence de résonance série et une fréquence de résonance parallèle, ladite fréquence de résonance parallèle dudit cinquième résonateur étant fixée pour coïncider avec la fréquence de résonance série dudit troisième résonateur, ladite branche parallèle comportant une seconde capacité (333) en série avec ledit cinquième résonateur (332) et, en parallèle sur cette seconde capacité, un second transistor de commutation (314) permettant de court-circuiter cette seconde capacité et pouvant être commandé par un second potentiel de commande.

7. Circuit de filtrage selon la revendication 6 **caractérisé en ce qu'**il comporte des résonateurs BAW de type SMR.

8. Procédé de réduction de l'interférence subie par un circuit de réception pour un téléphone mobile comportant un circuit de filtrage basé sur une cascade de cellules comportant chacune une branche parallèle dotée d'un premier BAW, et une branche série dotée d'un second BAW, ledit second BAW étant monté en série avec une capacité disposant d'un transistor de commutation branché à ses bornes ;
Le procédé comportant les étapes suivantes :

- détecter la présence d'un signal perturbateur proche de la bande d'utilisation du mobile susceptible de perturber la communication en cours,
- en réponse à la dite détection, commande d'un ou plusieurs transistors de manière à introduire l'effet des capacités correspondantes pour accroître la sélectivité du filtre.

9. Procédé selon la revendication 8 **caractérisé en ce que** les résonateurs sont de type SMR.

10. Procédé selon l'une des revendications 8 ou 9 **caractérisé en ce qu'**il s'applique à un téléphone mobile de 4ème génération.

## Fig. 1A

## Fig. 1B

# Fig. 2A

# Fig. 2B

Fig. 3

# Fig. 4A

# Fig. 4B

Fig. 5

Fig. 6

Fig. 7

Fig. 8A

Fig. 8B

Fig. 8C

Fig. 8D

Europäisches
Patentamt

European
Patent Office

Office européen
des brevets

# RAPPORT DE RECHERCHE EUROPEENNE

Numéro de la demande

EP 09 36 8005

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EL HASSAN M ET AL: "A New Method to Reconfigure BAW-SMR Filters Using CMOS Transistors" MICROWAVE SYMPOSIUM, 2007. IEEE/MTT-S INTERNATIONAL, IEEE, PI, 1 juin 2007 (2007-06-01), pages 1603-1606, XP031112255 ISBN: 978-1-4244-0687-6 * le document en entier * ----- | 1-10 | INV. H03H9/60 |
| A | EL HASSAN M ET AL: "Reconfiguration of Bulk Acoustic Wave Filters: Application to WLAN 802.11b/g (2.40-2.48 GHz)" ELECTRONICS, CIRCUITS AND SYSTEMS, 2006. ICECS '06. 13TH IEEE INTERNAT IONAL CONFERENCE ON, IEEE, PI, 1 décembre 2006 (2006-12-01), pages 395-398, XP031111509 ISBN: 978-1-4244-0394-3 * le document en entier * ----- | 1-10 | |
| A | US 2005/212612 A1 (KAWAKUBO TAKASHI [JP] ET AL) 29 septembre 2005 (2005-09-29) * le document en entier * ----- | 1-10 | DOMAINES TECHNIQUES RECHERCHES (IPC) H03H |

Le présent rapport a été établi pour toutes les revendications

| Lieu de la recherche | Date d'achèvement de la recherche | Examinateur |
|---|---|---|
| La Haye | 2 juin 2009 | Lecoutre, Renaud |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 09 36 8005

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-06-2009

| Document brevet cité au rapport de recherche | Date de publication | Membre(s) de la famille de brevet(s) | Date de publication |
|---|---|---|---|
| US 2005212612 A1 | 29-09-2005 | CN 1649265 A<br>JP 4053504 B2<br>JP 2005217852 A | 03-08-2005<br>27-02-2008<br>11-08-2005 |

EPO FORM P0460

Pour tout renseignement concernant cette annexe : voir Journal Officiel de l'Office européen des brevets, No.12/82